Europäisches Patentamt

European Patent Office

Office européen des brevets

(19)

(11) Publication number: **0 171 694**

A1

(12) # EUROPEAN PATENT APPLICATION

(21) Application number: **85109461.5**

(22) Date of filing: **30.07.85**

(51) Int. Cl.⁴: **C 30 B 15/26**

(30) Priority: **17.08.84 US 641650**

(43) Date of publication of application:
**19.02.86 Bulletin 86/8**

(84) Designated Contracting States:
**DE FR GB IT**

(71) Applicant: **International Business Machines Corporation
Old Orchard Road
Armonk, N.Y. 10504(US)**

(72) Inventor: **Kran, Alexander
73 Edge Hill Drive
Wappingers Falls New York 12590(US)**

(72) Inventor: **Smetana, Paul
37 Hillis Terrace
Poughkeepsie New York 12603(US)**

(72) Inventor: **Werlich, Harald Willy
19055 Skyline Blvd.
Los Gatos California(US)**

(72) Inventor: **Yung, Bwo-Han
6335 Nepo Drive
San Jose California 95119(US)**

(74) Representative: **Hobbs, Francis John
IBM United Kingdom Patent Operations Hursley Park
Winchester, Hants, SO21 2JN(GB)**

(54) **A process for controlling the growth of a crystal.**

(57) In a process for growing a boule of a crystal from a liquid melt, the temperature gradient profile of the meniscus and the phase change interface is detected by projecting an image of the meniscus through a lens onto a charge coupled device (CCD) detector array and the information provided by scanning the CCD is used to control the boule pull rate, the crucible and boule rotation rate, and the liquid melt temperature.

A PROCESS FOR CONTROLLING THE GROWTH OF A CRYSTAL

This invention relates to a process for controlling the growth of a crystal.

U.S-A- 4,242,589, 4,277,441 and 4,318,769 are all concerned with monitoring crystal growth. These prior documents disclose processes which employ a camera for forming and converting the image of the meniscus into an electric signal representing the image. Repetitive scanning is used but the location of the phase change is not used to control the process.

When a boule of a crystal is grown from a liquid melt in a controlled process, a meniscus of the material undergoing phase change is formed between the boule and the liquid melt. A process according to the present invention involves the steps of (1) projecting an image of the meniscus through a lens onto a charge coupled device detector array (CCD); (2) electrically scanning the output of the CCD signal to ascertain the temperature gradient profile of the meniscus and the phase change interface; and (3) controlling the boule pull rate, the crucible and boule rotation rate, and the liquid melt temperature on the basis of the temperature profile of the meniscus and the phase change interface.

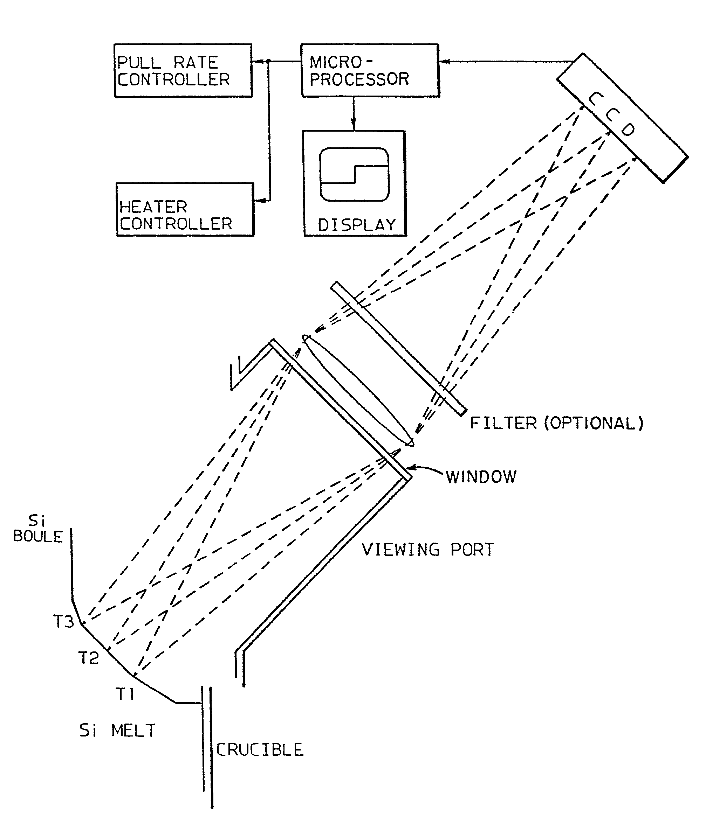

How the invention can be carried out will now be described by way of example, with reference to the accompanying drawing which is a schematic representation of a process embodying the invention. A material, for example silicon, is melted in a crucible. Typically this takes place in a Czochralski-type crystal growing apparatus. As the boule is formed, a meniscus is formed between the boule and the melt. An image of this meniscus is projected through a lens onto a charge coupled device detector array (CCD). By observing the output signal level which depends upon the emissivity of the object, the location of the boule/melt interface can be easily identified. A discrete filter may be placed between the sensor and the view port in order to avoid misleading information and incorrect identification, but such a filter is not essential.  The output information of the CCD is then used to control the boule pull rate, the crucible and the boule rotation rate and the liquid melt temperature.

The image of the meniscus projected through the lens on the CCD can be either an emission image or a reflection image.

The present invention is not limited to any particular type of crystal growing apparatus.  The invention is very suitable for use with a Czochralski-type apparatus, which is very well known in the art.

The present invention is applicable to crystal growing processes for any material.  It is, however, of particular economic interest and importance in the manufacture of crystals of silicon.  By means of the present invention, it is possible to automate the entire process.  This represents a great step forward over the prior art.  Classic optical techniques cannot be implemented becuase of the geometric constraint imposed by the crystal growing apparatus.  Even with good reflectivity of the hot melt surfaces, light projected through the viewing port is not returned to any monitoring device because of unfavourable angles.  A pyrometer, utilizing the self-luminous properties of the hot interface, measures totally radiated energy into the viewing solid angle.  This is an absolute measurement which cannot be measured with sufficient accuracy to effectively control the process.  The process of the present invention, however, solves these problems.

When used to form silicon crystals, the process of the present invention takes place at a very high temperature, e.g. around 1690°K, and in an inert atmosphere to prevent oxidation.

When the phase of certain elements changes from liquid to solid, their optical properties show a drastic change.  As silicon (or other semiconductor material) melts, its reflectivity increases and its absorptivity decreases.  The emissivity is higher when the silicon is in

0171694

solid phase. At the boule/melt interface, the temperature gradient from liquid to solid is around 2-3°K; therefore, in this binary phase system, we observe over a very small area, a significant variation in thermal radiation level. By determining specific zones of the boundary area and with careful calibration, one can control the crystal growing process.

CLAIMS

1.  A process for controlling the growth of a boule of a crystal from a liquid melt in which a meniscus of the material undergoing phase change is formed between the boule and the liquid melt in a crucible, the process comprising the steps of:

    (1) projecting an image of the meniscus through a lens onto a charge coupled device detector array (CCD);

    (2) electronically scanning the CCD to produce an output signal indicative of the temperature gradient profile of the meniscus and the phase change interface; and

    (3) controlling the boule pull rate, the crucible and boule rotation rate, and the liquid melt temperature, on the basis of the indicated temperature gradient profile of the meniscus and the phase change interface.

2.  A process as claimed in claim 1, wherein the projected image is an emission image.

3.  A process as claimed in claim 1, wherein the projected image is a reflective image.

4.  A process as claimed in any preceding claim, which is carried out in a Czochralski-type crystal growing apparatus.

5.  A process as claimed in any preceding claim, wherein the material is silicon.

## DOCUMENTS CONSIDERED TO BE RELEVANT

| Category | Citation of document with indication, where appropriate, of relevant passages | Relevant to claim | CLASSIFICATION OF THE APPLICATION (Int Cl.) |
|---|---|---|---|
| X | US-A-4 290 835 (D.A. YATES)<br><br>* Column 7, lines 1-46; column 14, lines 11-40 * | 1,2,4,5 | C 30 B 15/26 |
| A | US-A-4 217 165 (R.A. FROSCH)<br>* Column 4, lines 9-24; claims * | 1 | |

**TECHNICAL FIELDS SEARCHED (Int Cl.)**

C 30 B 15/26
C 30 B 15/20

The present search report has been drawn up for all claims

| Place of search | Date of completion of the search | Examiner |
|---|---|---|
| THE HAGUE | 10-08-1985 | BRACKE P.P.J.L. |